(19) Europäisches Patentamt
European Patent Office
Office européen des brevets

(11) EP 2 948 785 B1

(12) **EUROPÄISCHE PATENTSCHRIFT**

(45) Veröffentlichungstag und Bekanntmachung des Hinweises auf die Patenterteilung:
**21.12.2016 Patentblatt 2016/51**

(21) Anmeldenummer: **14700888.2**

(22) Anmeldetag: **17.01.2014**

(51) Int Cl.:
***G01R 31/36*** *(2006.01)*

(86) Internationale Anmeldenummer:
**PCT/EP2014/050905**

(87) Internationale Veröffentlichungsnummer:
**WO 2014/114564 (31.07.2014 Gazette 2014/31)**

(54) **VERFAHREN ZUR ERMITTLUNG EINES REGELUNGSTECHNISCHEN BEOBACHTERS FÜR DEN SOC**

METHOD FOR DETERMINING A CONTROL OBSERVER FOR THE SOC

PROCÉDÉ POUR DÉTERMINER UN OBSERVATEUR D'ÉTAT DE CHARGE RELEVANT DE LA TECHNIQUE DE RÉGULATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.01.2013 AT 500462013**
**06.11.2013 AT 507362013**

(43) Veröffentlichungstag der Anmeldung:
**02.12.2015 Patentblatt 2015/49**

(73) Patentinhaber: **AVL List GmbH**
**8020 Graz (AT)**

(72) Erfinder:
- **HAMETNER, Christoph**
**A-1020 Wien (AT)**
- **JAKUBEK, Stefan**
**A-1230 Wien (AT)**
- **SULJANOVIC, Amra**
**A-8052 Graz (AT)**

(74) Vertreter: **Patentanwälte Pinter & Weiss OG**
**Prinz-Eugen-Straße 70**
**1040 Wien (AT)**

(56) Entgegenhaltungen:
**DE-A1-102009 046 579** **DE-A1-102012 210 883**
**US-A1- 2013 006 455**

- **SCHMIDT A P ET AL: "Experiment-driven electrochemical modeling and systematic parameterization for a lithium-ion battery cell", JOURNAL OF POWER SOURCES, ELSEVIER SA, CH, Bd. 195, Nr. 15, 1. August 2010 (2010-08-01), Seiten 5071-5080, XP026991285, ISSN: 0378-7753 [gefunden am 2010-02-20]**

EP 2 948 785 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Die gegenständliche Erfindung betrifft ein Verfahren zur Ermittlung eines regelungstechnischen Beobachters zur Schätzung des SoC einer Batterie.

In an sich hinlänglich bekannten Batteriemanagementsystemen, z.B. für die Batterie eines Elektro- oder Hybridfahrzeugs, wird der Ladezustand (State-of-Charge, SoC) der Batterie bzw. einer Batteriezelle in Abhängigkeit von den im Fahrzeug gemessenen Größen, wie z.B. Lade- bzw. Entladestrom, Batteriespannung und Temperatur, ermittelt. Das wird häufig mit einem regelungstechnischen SoC-Beobachter gemacht, der ein, im Normalfall, nichtlineares Batteriemodell verwendet, das das nichtlineare Batterieverhalten der Batteriespannung in Abhängigkeit vom Lade- und Entladestrom modelliert. Der SoC-Beobachter schätzt dann auf Basis dieses Modells und der im Fahrzeug gemessenen Batteriespannung den tatsächlichen Ladezustand der Batterie. Das ist z.B. aus der DE 10 2009 046 579 A1 bekannt, die eine einfache äquivalente elektrische Schaltung als Modell der Zelle verwendet.

Darüber hinaus offenbart DE 10 2012 210 883 A1 einen nichtlinearen adaptiven Beobachtungsansatz zur Batterieladezustandsschätzung.

Ein Problem dabei ist, dass für jeden Batterietyp eigene Modelle benötigt werden. Solche Modelle sind aber schwierig zu parametrieren (z.B. elektro-chemische Modelle) und/oder sind nur in einem bestimmten Parameterbereich, z.B. nur innerhalb eines bestimmten Temperaturbereichs, vertrauenswürdig (z.B. elektrische Modelle auf Basis einer äquivalenten Schaltung) und/oder sind aufgrund ihrer Komplexität für Echtzeitanwendungen, und damit für Anwendung in einem Batteriemanagementsystem, ungeeignet.

Ein weiteres Problem ist die Erstellung des regelungstechnischen Beobachters selbst, der für unterschiedliche Modelle (Batterietypen) unter Umständen andere Anforderungen erfüllen muss. Häufig kommt hier zur nichtlinearen Zustandsschätzung ein Extended Kalman Filter zum Einsatz. Dabei findet in jedem Zeitschritt eine Linearisierung des nichtlinearen Modells statt. Je nach verwendeter Modellstruktur führt diese Vorgangsweise jedoch zu einem hohen bis sehr hohen Rechenaufwand, was die Umsetzung in einem Batteriemanagementsystem schwierig bzw. aufwendig macht.

Es ist daher eine Aufgabe der gegenständlichen Erfindung, ein Verfahren anzugeben, mit dem es ermöglicht wird, für einen beliebigen Batterietyp einen regelungstechnischen Beobachter strukturiert und zumindest teilweise automatisiert zu erstellen und der möglichst wenig Rechenaufwand benötigt.

Diese Aufgabe wird mit den Merkmalen des Anspruchs 1 gelöst. Dabei wird zuerst über ein datenbasiertes Modellierungsverfahren aus den Messdaten eines vorher ermittelten optimierten Versuchsplans ein nichtlineares Modell der Batterie, in Form eines lokalen Modellnetzwerks bestehend aus einer Anzahl von lokalen, linearen, zeitinvarianten, dynamischen Modellen, die jeweils in bestimmten Bereichen der Eingangsgrößen Gültigkeit haben, ermittelt. Für jedes derart ermittelte lokale Modell des Modellnetzwerkes wird dann ein lokaler Beobachter ermittelt. Der regelungstechnische Beobachter zur Schätzung des SoC ergibt sich dann aus einer Linearkombination der lokalen Beobachter. Solche datenbasierte Modellierungsmethoden bieten in diesem Zusammenhang den Vorteil, dass sie für verschiedene Batterietypen und auch für Echtzeitanwendungen geeignet sind. Darüber hinaus kann das Verfahren weitestgehend automatisiert ablaufen, sodass der Aufwand für die Erstellung des SoC-Beobachters reduziert werden kann.

Nachdem das Verfahren zur Erstellung des SoC-Beobachters auf einem Versuchsplan basiert, der mit einer echten Batterie durch reale Messungen durchgeführt wird, sind die damit erhaltenen Messwerte und Modelle abhängig vom Alterungszustand der Batterie zum Zeitpunkt der Messungen. Somit liefert der daraus erstellte Beobachter für den SoC für andere Alterungszustände ungenaue Schätzungen für den SoC. Um nun auch den Alterungszustand der Batterie in der Schätzung des SoC zu berücksichtigen ist es vorteilhaft, wenn zumindest eine Eingangsgröße oder zumindest ein Modellparameter oder zumindest eine Gültigkeitsfunktion des lokalen Modellnetzwerks, also des nichtlinearen Batteriemodells, durch zumindest eine Kenngröße für den Alterungszustand der Batterie skaliert wird. Auf diese Weise kann der SoC-Beobachter unabhängig vom aktuellen Alterungszustand der Batterie gute Schätzwerte für den SoC liefern bzw. den Alterungszustand der Batterie selbst als zusätzliche Schätzgröße bestimmen. Ein Vorteil dieser Methodik ist also, dass über einen einzelnen Parameter die Änderung des Alterungszustandes berücksichtigt werden kann.

Die gegenständliche Erfindung wird nachfolgend unter Bezugnahme auf die Figuren 1 bis 8 näher erläutert, die beispielhaft, schematisch und nicht einschränkend vorteilhafte Ausgestaltungen der Erfindung zeigen. Dabei zeigt

Fig.1 die Änderung des SoC in Abhängigkeit vom Laststrom,
Fig.2 einen initialen Versuchsplan zur Bestimmung eines optimierten Versuchsplans,
Fig.3 einen optimierten Versuchsplan,
Fig.4 eine Darstellung der Verbesserung des Informationsgehalts und der Versuchszeit durch den optimierten Versuchsplan,
Fig.5 die Einbindung des SoC-Beobachters in ein Batteriemanagementsystem,
Fig.6 ein Blockschaltbild eines linearen Modellnetzwerkes und
Fig.7 und 8 jeweils einen Vergleich des geschätzten SoC mit einem gemessenen SoC.

In einem ersten Schritt des erfindungsgemäßen Verfahrens wird ein einfaches Ausgangsmodell der Batterie bzw. Batteriezelle ermittelt. Im nachfolgenden werden die Begriffe Batterie und Batteriezelle im Sinne der Erfindung als gleichwertig angesehen. Dabei wird von einem beliebigen, bekannten Modell einer beliebigen Batteriezelle ausgegangen. Das bekannte Batteriemodell ist z.B. ein von einer anderen Batterie bekanntes Modell, ein lineares Batteriemodell, oder ein nicht lineares Batteriemodell. Ein einfaches lineares Batteriemodell kann z.B. ermittelt werden, indem ein Stromimpuls an die Batterie bzw. Batteriezelle angelegt wird und dabei die sich ergebende Spannung gemessen wird. Auch die Anwendung der bekannten Impedanzspektroskopie könnte zur Erstellung eines einfachen Batteriemodells genutzt werden. Aus diesen Daten kann dann mittels Methoden der Identifikation ein lineares Batteriemodell, z.B. ein einfacher Strom-Spannungszusammenhang, ermittelt werden. Obwohl ein solcher Sprungversuch nur für einen bestimmten Arbeitspunkt der Batterie bzw. Batteriezelle und nur für den konkreten Stromimpuls gilt, reicht ein derart einfaches Ausgangsmodell als Ausgangspunkt für die erfindungsgemäße Methodik aus, wie nachfolgend noch beschrieben.

Basierend auf dem einfachen linearen Ausgangsmodell der Batterie wird nun mittels einer modellbasierten Design of Experiments (DoE) Methode die optimale Anregung für die Batterie bzw. Batteriezelle ermittelt. Dabei sollen ein möglichst großer, vorzugsweise der gesamte, Betriebsbereich der Batteriezelle abgedeckt werden, eine hohe Genauigkeit auch für hochdynamische Anregungen erzielt werden und auch Effekte der Batteriezelle wie Lade-Entlade Hysterese und Relaxation (Schwingverhalten) berücksichtigt werden. Gängige Verfahren zur Versuchsplanung für nichtlineare Systeme verwenden z.B. amplitudenmodulierte, pseudozufällige binäre Signale (APRB-Signale) zur Anregung der Systemdynamik. Diese Verfahren können in der vorliegenden Anwendung bei Batterien jedoch nicht eingesetzt werden, da der SoC direkt vom Anregungssignal (dem Laststrom der Batteriezelle) abhängig ist, z.B. gemäß der Beziehung

$$SoC(t) = SoC_0 + \int_{\tau=0}^{t} \frac{\eta_I(I)I(\tau)}{C_n} d\tau ,$$

mit I(t) dem momentanen Laststrom, $C_n$ der nominellen Zellkapazität und $\eta_I(I)$ dem Coulomb'schen Wirkungsgrad. Es muss daher bei der Anwendung bei Batterien ein anderer Ansatz gesucht werden. Das DoE muss dabei auch sicherstellen, dass das Anregungssignal eine geeignete und ausreichende Anregung der Batteriezelle darstellt und gleichzeitig, dass auch der gesamte Betriebsbereich des SoC abgedeckt ist. Außerdem wird vorzugsweise auch die Zeit für die Durchführung der Batterietests mit berücksichtigt.

Ein optimales modellbasiertes DoE wird häufig mittels der sogenannten Fisher Informationsmatrix $I_{FIM}$ und einem Beurteilungskriterium, wie z.B. einem D-optimalen Beurteilungskriterium, bestimmt. Nach diesem Beurteilungskriterium ist die Determinante $J_{FIM}$ der Fisher Informationsmatrix $I_{FIM}$ zu maximieren. Neben dem D-optimalen Beurteilungskriterium gibt es natürlich noch weitere bekannte Beurteilungskriterien, die ebenfalls angewendet werden könnten. Das ist hinlänglich bekannt und wird hier nicht näher erläutert.

Dabei kann das zuvor ermittelte (z.B. aus einzelnen Sprungversuchen) einfache Ausgangsmodell $y=f(_\psi)$ zur Bestimmung der Fisher Informationsmatrix verwendet werden. Die Fisher Informationsmatrix $I_{FIM}$ basiert bekannterweise auf der partiellen Ableitung des Modellausgangs y nach den Modellparametern $\psi$, in der Form

$$I_{FIM} = \frac{1}{\sigma^2} \sum_{k=1}^{N} \frac{\partial y(k,\psi)}{\partial \psi} \frac{\partial y(k,\psi)^T}{\partial \psi}$$

Für die gegenständliche Anwendung wird das Anregungssignal ausgehend von einer bestimmten Anzahl von Designpunkten, die jeweils durch den Laststrom und dem SoC-Wert gegeben sind, zu Beginn vorgegeben. Das Ziel der folgenden Optimierung ist eine optimale zeitlich sequentielle Anordnung solcher Designpunkte, um die oben erwähnten Anforderungen an die Anregung zu erfüllen. Für jeden Designpunkt hängt das Vorzeichen des Laststromes I (als Laden oder Entladen) und die Dauer des Laststromes I vom zu erreichenden SoC und dem vorherigen SoC ab, wie in Fig.1 dargestellt. Innerhalb des zulässigen Parameterbereichs 1 (der Eingangsraum), kann ausgehend von einem bestimmten aktuellen SoC 2, 3, ein neuer SoC 4, 5 nur erreicht werden, wenn der Laststrom I entweder für eine bestimmte Zeitdauer erhöht (laden) oder für eine bestimmte Zeitdauer erniedrigt (entladen) wird. Folglich hängt hierbei auch die Dauer dieser Lade- bzw. Entladepulse und damit auch die Testzeit T direkt von dieser zeitlich sequentiellen Abfolge und der jeweiligen Zuordnung von Laststrom und SoC-Wert der Designpunkte ab. Damit kann die Testzeit T auch Gegenstand der Optimierung und daher des optimalen DoE sein. Das kann z.B. erreicht werden, indem eine Ergebnisfunktion

$$J_{opt} = \alpha \frac{J_{FIM,init}}{J_{FIM,opt}} + (1-\alpha)\frac{T_{opt}}{T_{init}}$$

minimiert wird. Dabei bezeichnen Größen mit dem Index "init" die entsprechenden Größen für den initialen Versuchsplan (Ausgangspunkt der Optimierung) und "opt" die optimierten Größen, als Ergebnis der Optimierung. Der Gewichtungsparameter $0 \leq \alpha \leq 1$ gewichtet zwischen Genauigkeit und Testzeit. Je größer $\alpha$ wird, umso größer ist der Informationsgehalt des Anregungssignals, während die Reduktion der Testzeit stärker gewichtet wird, je kleiner $\alpha$ gewählt wird. Solche Optimierungsprobleme können z.B. mittels eines heuristischen Optimierungsverfahren (z.B. ein simulated annealing Verfahren), oder anderen bekannten Verfahren, gelöst werden, wie hinlänglich bekannt ist.

In Fig.2 ist beispielhaft ein Ausgangs-DoE (initialer Versuchsplan) bestehend aus einer Anzahl von zeitlich sequentiellen Designpunkten dargestellt. Der Versuchsplan ergibt sich aus einer entsprechend gewählten Abfolge der gewünschten Designpunkte (definiert über Laststrom und SoC). Um die Spannungshysterese und das Relaxationsverhalten der Batteriezelle erfassen zu können, können einzelnen Lade- oder Entladepulsen Phasen mit Laststrom I=0 folgen. Dieses Ausgangsdesign war Ausgangspunkt für einen simulated annealing Algorithmus zur Ermittlung eines optimierten DoE (optimierter Versuchsplan), wie in Fig.3 dargestellt. Die Testzeit ergibt sich aus der sequentiellen Abfolge und der Zuordnung von Laststrom und SoC der Designpunkte. Fig.4 zeigt die Verbesserung der Determinante $J_{FIM}$ der Fisher Informationsmatrix $I_{FIM}$ um einen Faktor von ungefähr fünf bei gleichzeitiger Verkürzung der Testzeit T um ungefähr 7% bei Durchführung der Optimierung.

Der optimierte Versuchsplan deckt durch diese Vorgehensweise im Wesentlichen den gesamten Betriebsbereich der Batteriezelle ab und erfasst im Wesentlichen das gesamte nichtlineare dynamische Verhalten der Batteriezelle. Der Versuchsplan wird danach auf dem Prüfstand für die Batteriezelle abgefahren, d.h. die Batteriezelle wird mit den einzelnen Designpunkte in der ermittelten zeitlichen Sequenz gemäß dem Versuchsplan beaufschlagt, und es werden dabei Messungen an der Batteriezelle vorgenommen, um Zustandsgrößen der Batterie zu erfassen. Das kann auch automatisiert oder teilautomatisiert erfolgen. Aus diesen Messwerten kann dann automatisiert ein Modell der Batteriezelle bzw. Batterie ermittelt werden. Dabei werden z.B. Strom, Spannung und Temperatur der Batterie gemessen, wobei auch der initiale Versuchsplan zu Beginn der Messung als bekannt angenommen wird.

Zur Erstellung eines nichtlinearen Modells der Batterie kann man sich ebenfalls an sich bekannter Methoden nichtlinearer Modellidentifikation bedienen. Nachfolgend wird diese datenbasierte Modellierung anhand eines lokalen Modellnetzwerks (local model network, LMN) beschrieben, wie nachfolgend anhand von Fig.6 näher erläutert. Ein LMN interpoliert zwischen lokalen Modellen, die jeweils in bestimmten Betriebsbereichen (bzw. Bereichen der Eingangsgrößen) Gültigkeit haben.

Dabei kann jedes i-te lokale Modell $LM_i$ des LMN aus zwei Teilen bestehen, nämlich aus einer Gültigkeitsfunktion $\Phi_i$ und einem Modellparametervektor $\theta_i$. Der Modellparametervektor $\theta_i$ umfasst alle Parameter für das i-te Modell und die Gültigkeitsfunktion $\Phi_i$ definiert den Gültigkeitsbereich des i-ten lokalen Modells (innerhalb des Eingangsraumes). Ein lokaler Schätzwert der Ausgangsgröße $\hat{y}_i(k)$ als Ausgang des i-ten lokalen Modells $LM_i$ zum Zeitpunkt k ergibt sich aus $\hat{y}_i(k) = x^T(k)\,\theta_i$, wobei x(k) einen Regressionsvektor bezeichnet, der gegenwärtige und vergangene Ein- und Ausgänge enthält, z.B. den Zellstrom I(k) und dessen letzten vier vergangene Werte I(k-1) ... I(k-4), den letzten SoC(k-1) und die Zelltemperatur T(k-1). Der globale Modellausgang $\hat{y}(k)$, z.B. die Zellspannung U(k), ergibt sich dann aus einer Linearkombination mit einer Wichtung der M lokalen Modellausgänge durch die Gültigkeitsfunktion $\Phi_i$, in der Form

$$\hat{y}(k) = \sum_{i=1}^{M} \Phi_i(k)\hat{y}_i(k)$$

Das nichtlineare Systemverhalten der Batterie wird durch das LMN folglich über lokal gültige, lineare Modelle beschrieben. Diese Teilmodelle sind jeweils in einem gewissen Teilbereich (definiert über Strom, SoC, Temperatur, etc.) des gesamten Arbeitsbereichs gültig.

Z.B. könnte der Modellausgang durch y(k) = U(k) und der Regressionsvektor durch $x(k) = [U(k-1), U(k-2), ..., U(k-n), I(k), I(k-1), ..., I(k-m), T(k-1), SoC(k-1), 1]^T$ gegeben sein, wobei m und n die entsprechenden Systemordnungen angeben. Der Modellparametervektor $\theta_i$ wäre dann z.B. $[a_{U,1}, a_{U,2}, ..., a_{U,n}, b_{I,0}, b_{I,1}, ... b_{I,m}, b_{T,1}, bS_{oC,1}, C_0]$. U bezeichnet dabei die Spannung der Batterie, I den Strom und T die Temperatur, die in der jeweiligen Systemordnung (k), (k-1), ... (k-n) aus dem ermittelten und durchgeführten Versuchsplan als Messwerte bekannt sind und als Trainingsdaten für die Modellidentifikation dienen. Das Ergebnis des Versuchsplans wird folglich für die Modellidentifikation herangezogen, wobei die Modellparameter bzw. der Modellparametervektor $\theta_i$ durch eine hinlänglich bekannte Optimierung, z.B. durch die Methode der kleinsten Fehlerquadrate, die den Fehler zwischen geschätztem Ausgang und gemessenem Ausgang minimiert, oder ähnlicher Optimierungsmethoden, ermittelt wird.

Als Ergebnis erhält man ein nichtlineares Modell der Batterie, das den Ausgang $\hat{y}(k)$, z.B. U(k), als Funktion der Eingangsgrößen, z.B. Strom I und Temperatur T, sowie von vergangenen Werten dieser Größen vorhersagt

Aus dem derart ermittelten nichtlinearen Modell der Batterie in Form des LMN kann dann ein regelungstechnischer Beobachter für den SoC ermittelt werden, was hier am Beispiel eines Fuzzy-Beobachters beschrieben wird. Die Verwendung eines Fuzzy-Beobachters ermöglicht eine einfache und automatisierte Parametrierung des nichtlinearen Zustandsbeobachters. Durch die stationäre Auslegung der lokalen Filter ist eine echtzeitfähige Implementierung möglich, da der Rechenaufwand in jedem Zeitschritt gering ist (im Gegensatz zum z.B. Extended Kalman Filter). Jedes lokale Modell des LMN ist ein lineares, zeitinvariantes, dynamisches System. Daher wird unter Verwendung der Standard Kalmanfiltertheorie ein lokaler Beobachter für jedes lokale lineare Zustandsraummodell erstellt. Ein globaler Filter ergibt sich dann aus einer Linearkombination der lokalen Filter. Das nichtlineare Beobachterdesign umfasst daher die Beschreibung des nichtlinearen Systems als lokale, lineare Zustandsraummodelle. Im Wesentlichen wird dazu der Zustandsvektor z(k-1) des Systems durch den Zustand SoC(k-1), der vorher als Eingang für die Ermittlung des LMN gedient hat, ergänzt. Das ergibt sich aus einer Kombination des LMNs mit dem relativen SoC-Modell von vorhin in der Form $SoC(k) = SoC(k-1) + \frac{T_S}{C_n} i(k)$, wobei Ts die Samplingzeit bezeichnet. Für das i-te lokale Modell erhält man gemäß dem Zustandsraummodell den Zustandsvektor $z_i(k)=A_iz(k-1)+B_iu(k)$, mit der Systemmatrix $A_i$, der Eingangsmatrix $B_i$ und dem Eingangsvektor u(k), wobei der Zustandsvektor z(k-1) den Zustand SoC(k-1) und die Systemmatrix $A_i$ und die Eingangsmatrix $B_i$ die vorher ermittelten Modellparameter enthält. Daraus folgt der Zustandsvektor für den Systemzustand wieder durch Wichtung der lokalen Zustände mit der Gültigkeitsfunktion $\Phi_i$ zu $z(k) = \sum_{i=1}^{M} \Phi_i(k-1)\{A_i z(k-1) + B_i u(k)\}$ und der globale Modellausgang

$$y(k) = Cz(k) \text{ mit } C=[1\ 0\ \ldots\ 0\ 0].$$

Der Zustandsvektor z(k) enthält im Beispiel von oben vergangene Ausgänge und den Ladezustand gemäß $z(k) = [U(k-1), U(k-2), \ldots, U(k-n), SoC(k-1)]^T$ und der Eingangsvektor u(k) enthält die aktuellen und zeitverzögerten Eingangsgrößen (und den Offset-Term der lokalen Modelle) in der Form u(k) = [I(k), I(k-1), ... , I(k-m), T(k-1), 1].

Ein Beobachter ist dabei notwendig, da das relative SoC-Modell über einen längeren Zeitraum unzuverlässig ist und falsche Ergebnisse liefert und weiters dazu der initiale Ladezustand exakt bekannt sein muss, was in der Regel nicht der Fall ist. Der Beobachter kann diesen Zustand basierend auf gemessenen echten Eingangs- und Ausgangsgrößen adaptieren und somit Fehler, die durch die falsche Initialisierung bzw. durch die Unzuverlässlichkeit des Modells entstehen, kompensieren.

Dazu kann für jedes lokale Modell des LMN ein lokaler Kalman Filter mit der Verstärkungsmatrix $K_i$ ermittelt werden, um den lokalen Zustand zu schätzen. Der geschätzte Zustand $\hat{z}(k)$, der den geschätzten SoC enthält, folgt dann aus den Gleichungen

$$\hat{z}(k) = \sum_{i=1}^{M} \Phi_i(k-1)\left\{z_i^*(k) + K_i\left[y(k) - \hat{y}(k)\right]\right\}$$

mit

$$z_i^*(k) = A_i\hat{z}(k-1) + B_iu(k) \text{ und } \hat{y}(k) = \sum_{i=1}^{M} \Phi_i(k-1)Cz_i^*(k)$$

Die Bestimmung der Kalman Verstärkungsmatrix $K_i$ erfolgt z.B. über die bekannte diskrete, algebraische Riccatigleichung (DARE) mit den Kovarianzmatrizen, die das Messrauschen und das Prozessrauschen beschreiben. Diese Kovarianzmatrizen können dabei z.B. über bekannte Verfahren aus den auf dem Prüfstand erfassten Messwerten bestimmt werden.

Der Kovarianzwert der das Prozessrauschen des SoC in den Kovarianzmatrizen beschreibt kann aber auch als einstellbarer Tuningparameter für den nichtlinearen SoC-Beobachter betrachtet und herangezogen werden, wie anhand der Fig.7 und 8 gezeigt. Die beiden Figs.7 und 8 zeigen die Funktion des regelungstechnischen Beobachters.

In beiden Figuren erkennt man, dass sich die Schätzung des SoC (jeweils die strichlierte Kurve Diagramm) auch bei beliebigen Ausgangsdaten an den tatsächlichen Wert des SoC annähert. In Fig.8 wurde die Gewichtung des SoC im Zustand erhöht, was zu einer schnelleren Konvergenz, aber zu einem leicht erhöhten Fehler führt.

Der ermittelte regelungstechnische Beobachter zur Schätzung des SoC lässt sich, wie in Fig. 5 dargestellt, in ein Batteriemanagementsystem 11 integrieren. Der Laststrom I einer Batterie 10 erzeugt eine Batteriespannung U und eine Batterietemperatur T, die als Messgrößen dem Batteriemanagementsystem 11 zugeführt werden. Darin ist das erfindungsgemäß ermittelte erweiterte Zustandsraummodell 12 und der nichtlineare Beobachter 13 implementiert, der den aktuellen SoC schätzt. Der geschätzte SoC kann dann entsprechend weiterverwendet werden, z.B. in der Batteriemanagementeinheit 11 selbst, oder in einer nicht dargestellten Batterie- oder Fahrzeugsteuereinheit.

Neben der Schätzung des Ladezustandes SoC ist die Bestimmung des Alterungszustandes (State-of-Health, SoH) wichtig, um ein Kriterium für die Güte der Batterie 10 angeben zu können. Für den SoH gibt es jedoch noch keine allgemein gültige Definition. Oftmals wird der Alterungszustand SoH einer Batterie 10 durch eine Kenngröße, wie z.B. als Verhältnis der verfügbaren Kapazität $C_{akt}$ der Batterie im Vergleich zur bekannten Nennkapazität $C_{init}$ der Batterie angegeben, also $C_{ak}t/C_{init}$. Um einen effizienten Einsatz der Batterie 10 zu ermöglichen und somit auch eine möglichst lange Lebensdauer zu erzielen, soll vorzugsweise auch der SoH, oder eine Kenngröße dafür, möglichst exakt bestimmt werden, z.B. von der Batteriemanagementeinheit 11, da der aktuelle Alterungszustand SoH auch die Bestimmung des Ladezustandes SoC beeinflusst. Für eine exakte Bestimmung des Ladezustandes SoC einer gealterten Batterie 10 ist es daher vorteilhaft, wenn auch der jeweilige aktuelle Alterungszustand SoH bei der Bestimmung des Ladezustandes SoC berücksichtigt wird. Nachfolgend wird nun beschrieben, wie der oben beschriebene SoC-Beobachter ergänzt werden kann, um auch den Alterungszustand SoH zu berücksichtigen bzw. zu ermitteln.

Im Gegensatz zu klassischen Modellierungsansätzen (chemisch-physikalische Modelle, Equivalent-Circuit Modelle, etc.) enthält das oben beschriebene, rein datenbasierte (Black-Box) Batteriemodell in Form des LMN, bzw. das davon abgeleiteten Zustandsraummodell 12, keinerlei physikalische Information über die Batterie 10 selbst. Die im Modellparametervektor $\theta_i$ enthaltenen Modellparameter, stehen allerdings über die Beziehung $\hat{y}_i(k) = x^T(k)\theta_i$ in in Zusammenhang mit den Eingangsgrößen im Regressionsvektor x(k) und mit der Ausgangsgröße y(k). Diese Interpretierbarkeit des lokalen Modellnetzwerkes LMN kann nun dazu genutzt werden, um Einflussgrößen für den Alterungszustand SoH aus dem LMN zu bestimmen bzw. zu extrahieren und über diese Einflussgrößen, Einfluss auf das Batteriemodell bzw. auf die Schätzung des SoC zu nehmen. Das Ziel dabei ist, durch Adaption dieser Einflussgrößen auch das dynamische Verhalten der Ausgangsgröße y(k), z.B. der Batteriespannung U(k), von alternden Batterien 10 mit dem LMN, bzw. dem daraus abgeleiteten Zustandsraummodell 12, wiederzugeben und damit eine genaue Schätzung des SoC zu ermöglichen. Zusätzlich kann dadurch der Alterungszustand SoH als weitere Größe bestimmt, ausgegeben und weiter verwendet werden.

Im einfachsten Fall handelt es sich bei der Kenngröße für den Alterungszustand SoH um die verfügbare Kapazität $C_{akt}$, bzw. um das Verhältnis der verfügbare Kapazität $C_{akt}$ im Vergleich zur Nennkapazität $C_{init}$, also $C_{akt}/C_{init}$. Es kann jedoch als Kenngröße für den Alterungszustand SoH auch der aktuelle Innenwiderstand $R_{akt}$ oder das Verhältnis von aktuellen Innenwiderstand der gealterten Batterie $R_{akt}$ im Vergleich zum bekannten Innenwiderstand einer neuen Batterie $R_{init}$, also $R_{ini}t/R_{akt}$, oder eine Kombination davon, berücksichtigt werden. Ein Batteriemodell in Form des LMN kann dann durch Vorgabe der Kenngröße, z.B. $C_{akt}/C_{init}$ und/oder $R_{akt}/R_{init}$, adaptiert werden, um das Verhalten der Ausgangsgröße y(k) bei bekannten Eingangsgrößen x(k) für beliebige, sich ergebende Alterungszustände SoH zu simulieren, wie in Fig.9 angedeutet. Dabei wird die Wirkung dieser Kenngröße(n) auf zumindest einen Modellparameter im Modellparametervektor $\theta_i$, und gegebenenfalls auch auf die Gültigkeitsfunktionen $\Phi_i$, und/oder auf zumindest eine Eingangsgröße x(k) umgerechnet, wodurch eine Anpassung des statischen und dynamischen Verhaltens des nichtlinearen Batteriemodells erfolgt. Gleichzeitig kann mit einem solchen ergänzten Batteriemodell aus dem davon abgeleiteten Beobachter für den Ladezustand SoC, wie oben beschrieben, auch der Ladezustand SoC in Abhängigkeit vom aktuellen Alterungszustand SoH ermittelt werden. Das soll nachfolgend am obigen Beispiel erläutert werden.

Durch die Interpretierbarkeit der lokal linearen Modelle $LM_i$ des lokalen Modellnetzwerks LMN können die Modellparameter, wie z.B. $a_{U,1}$, $a_{U,2}$, ..., $a_{U,n}$, $b_{I,0}$, $b_{I,i}$, ... $b_{I,m}$, $b_{T,1}$, $b_{SoC,1}$, $C_0$, die den Modellparametervektor $\theta_i$ bzw. die Systemmatrix $A_i$ im Zustandsraummodell 12 bestimmen, entsprechend verändert werden, um die Alterung der Batterie 10 im Batteriemodell zu berücksichtigen. Gleichfalls können auch die Eingangsgrößen x(k) des lokalen Modellnetzwerks LMN bzw. die Zustandsgrößen im Zustandsraummodell 12 verändert werden.

Folgend sind beispielhaft Möglichkeiten angegeben, um die Kenngröße(n) für den Alterungszustand SoH zu berücksichtigen:

- Anpassung des Innenwiderstands: Über den Modellparameter $b_{I,0}$, der mit dem aktuellen Strom I(k) zusammenhängt und der bei einer Ausgangsgröße U(k) die Eigenschaft eines Widerstandes hat, kann direkt der Innenwiderstand R der Batterie 10 beeinflusst werden. Damit kann der Modellparameter $b_{I,0}$ z.B. gemäß der Kenngröße $R_{akt}/R_{init}$ skaliert werden.

- Anpassung der Stationärverstärkung: Über die den Eingangsgrößen zugeordneten Modellparameter $b_{I,1}$, ... $b_{I,m}$, $b_{T,1}$, $b_{SoC,1}$ oder direkt über die Eingangsgrößen kann die Stationärverstärkung der Übertragungsfunktion (als Quotient von Eingang und Ausgang) angepasst werden.

- Anpassung der Kapazität im relativen SoC-Modell: Der Beobachter für den SoC berücksichtigt den Zusammenhang zwischen Strom und SoC über das relative SoC-Modell in der Form $SoC(k) = SoC(k-1) + \frac{T_S}{C_n} i(k)$. Durch Anpassung oder Skalierung der Kapazität $C_n$ kann dabei die Änderung der Kapazität über die Alterung berücksichtigt werden. Die Skalierung kann dabei in Abhängigkeit von der Kenngrößen, z.B. $C_{akt}/C_{init}$ erfolgen, gegebenenfalls unter Berücksichtigung des aktuellen SoC.

- Eine Kenngröße, z.B. $C_{akt}/C_{init}$, kann dazu genutzt werden, um Eingangssignale (bzw. Zustände im Zustandsraummodell) des Systems zu skalieren. Z.B. in Form einer SoC-Korrektur im Batteriemodell oder im Zustandsraummodell 12, z.B. über den Modellparameter $b_{SoC,1}$. Die Skalierung kann dabei in Abhängigkeit von der Kenngröße, z.B. $C_{akt}/C_{init}$, erfolgen, beispielsweise durch $SoC_{norm} = SoC^*C_{init}/C_{akt}$, wobei SoC der geschätzte SoC ist und $SoC_{norm}$ der skalierte und rückgeführte SoC.

- Eine Kenngröße, z.B. $C_{akt}/C_{init}$, kann dazu genutzt werden, um über die Modellparameter $b_{I,1}$, ... $b_{I,m}$ die Stationärverstärkung $K_i$ der Übertragungsfunktionen der lokal linearen Modelle $LM_i$ und den Batteriestrom zu korrigieren, z.B. durch $K_{i,norm} = K_i^* C_{akt}/C_{init}$, wobei $K_i$ die sich aus dem Modell ergebende Stationärverstärkung ist und $K_{i,norm}$ die skalierte.

Bei Kenntnis oder Vorgabe der Kenngröße, kann damit das nichtlineare Batteriemodell LMN bzw. das Zustandsraummodell 12 und damit die Schätzung des SoC an den aktuellen Alterungszustand angepasst werden. Die konkrete Art der Skalierung in Abhängigkeit von der Kenngröße ist hierbei nicht entscheidend, sondern es gibt natürlich vielfältigste Möglichkeiten, wie skaliert wird.

Die Kenngröße für den Alterungszustand SoH, also z.B. die Kapazität $C_{akt}$ oder der Innenwiderstand $R_{akt}$, ist aber in der Regel nicht direkt messbar und daher nicht bekannt. Diese Kenngröße, bzw. der damit in Zusammenhang stehende Alterungszustand SoH, soll daher durch den nichtlinearen Beobachter mitgeschätzt werden. Der oben beschriebene nichtlineare Beobachter 13 wird daher nun um die Schätzung des Alterungszustandes SoH, bzw. einer Kenngröße davon, erweitert.

Dieser kombinierte SoH/SoC-Beobachter basiert auf dem erweiterten nichtlinearen Batteriemodell in Form des lokalen Modellnetzwerkes LMN bzw. dem daraus abgeleiteten erweiterten Zustandsraummodell 12. Die Kenngröße, wie z.B. $C_{akt}$, $C_{akt}/C_{init}$, $R_{akt}$ oder $R_{akt}/R_{init}$, beeinflusst dabei direkt oder indirekt Eingangsgrößen und/oder Modellparameter dieses Zustandsraummodells, wie oben beschrieben.

Bei der Wahl der Architektur des kombinierten SoH/SoC-Beobachters kann man unterscheiden zwischen einem vollständigen Beobachter für SoC und SoH und einem kaskadierten Beobachter.

Beim vollständigen Beobachter werden SoC und SoH (bzw. die Kenngrößen für den Alterungszustand SoH) gleichzeitig geschätzt. Ein wichtiger Punkt ist dabei die Berücksichtigung der unterschiedlichen Zeitkonstanten für die Beobachtung von SoC und SoH, da sich der SoH in der Regel viel langsamer ändert als der SoC.

Beim kaskadierten Beobachter gibt es einen inneren Beobachter(kreis) welcher darauf abzielt, den SoC möglichst exakt zu bestimmen und der oben beschrieben ist. Ein auf dem inneren Beobachter 13 aufbauender äußerer Beobachter 14 stellt dann einen übergeordneten Schätzer für die SoH-Kenngröße dar, wie in Fig.10 dargestellt. Der Vorteil des kaskadierten Beobachters ist, dass die unterschiedlichen Zeitkonstanten für die beiden Beobachter bereits indirekt über die Architektur berücksichtig werden. Der SoH-Schätzer kann durch die Trennung in einen inneren und äußeren Beobachter somit auch mit einer deutlich geringeren Abtastzeit betrieben werden. Der kaskadierte Beobachter wird daher bevorzugt.

In Fig.10 ist der Beobachter aus Fig.5 um einen Beobachter 14 für den Alterungszustand SoH, bzw. einer Kenngröße dafür, wie hier z.B. $\hat{C}_{akt}$, in kaskadierter Ausführung ergänzt worden. Das ermittelte erweiterte Zustandsraummodell 12, ergänzt um die oben beschriebene Berücksichtigung der Kenngröße für den Alterungszustand SoH, und der nichtlineare Beobachter 13 für den Ladezustand SoC sind wiederum vorgesehen. Hinzugekommen ist ein Beobachter 14 für die Schätzung der Kenngröße des Alterungszustandes, hier der aktuellen Kapazität $\hat{C}_{akt}$.

Zur Schätzung der Kenngröße wird ein Beobachtungsfehler e bezüglich der Kenngröße minimiert. Der Beobachtungsfehler e wird z.B. aus der Differenz aus der gemessenen Ausgangsgröße y, hier die Batteriespannung U, und der vom nichtlinearen Batteriemodell bzw. vom Zustandsraummodell 12 berechneten Ausgangsgröße $\hat{y}$, hier die geschätzte Batteriespannung $\hat{U}$, ermittelt. Um die Kenngröße zu schätzen, wird der Beobachtungsfehler e in einem gewissen Zeitfenster t=0...T betrachtet, wobei jedoch nur zurückliegende Werte berücksichtigt werden. Das Ziel der Schätzung/Optimierung im Beobachter 14 ist nun, ein bestimmtes Gütemaß bezüglich des Beobachtungsfehlers e zu minimieren. Als Gütemaß kann z.B. das Minimum der Fehlerquadrate $\int_{t=0}^{T} e^2(t)dt = \min_{\hat{C}_{akt}}$ herangezogen werden. Alternativ kann auf eine möglichst symmetrische Fehlerverteilung abgezielt werden, z.B. in der Form $\int_{\varepsilon=0}^{e_{max}} \left(h(\varepsilon) - h(-\varepsilon)\right)^2 d\varepsilon = \min_{\hat{C}_{akt}}$, oder auf eine Minimierung des Offsets des Schätzfehlers, z.B. in der Form $\int_{\varepsilon=-e_{max}}^{e_{max}} h(\varepsilon)\varepsilon\, d\varepsilon = \min_{\hat{C}_{akt}}$, wobei die Funktion eine beliebige Verteilungsfunktion, z.B. die Normalverteilung, sein kann.

Dabei kann man so vorgehen, dass im Zeitfenster t=0...T die Ausgangsgröße $\hat{U}$ für verschiedene Kapazitäten $C_{akt}$, z.B. zwischen einem vorgegebenen $C_{min}$ und einem $C_{max}$, vom nichtlinearen Batteriemodell bzw. vom Zustandsraummodell 12 berechnet und der SoC geschätzt wird und daraus mit der zum jeweiligen Zeitpunkt zugehörige gemessenen Ausgangsgröße U der Beobachtungsfehler e ermittelt wird. Daraus kann dann über das Gütemaß die Kapazität $C_{akt}$ bestimmt werden, die den Beobachtungsfehler e gemäß dem Gütemaß minimiert. Durch Anpassung von $C_{akt}$ wird also ein bestimmtes Gütemaß des Beobachtungsfehlers e minimiert, was letztendlich dazu führt, dass jene Kapazität $C_{akt}$ ermittelt wird, welche das Verhalten der Batterie 10 am besten erklärt.

Dabei können auch Rand- und Nebenbedingungen berücksichtigt werden, z.B. monotoner Abfall der Kapazität $C_{akt}$ über der Zeit, da die Batterie 10 nur älter werden kann, nicht jedoch jünger. Der kombinierte Beobachter hat also generell zum Ziel, dass die Abweichungen der geschätzten Zustände von den tatsächlichen Werten minimiert und dabei Rand- und Nebenbedingungen in Form von Gleichheits- oder Ungleichheitsbeschränkungen berücksichtigt werden. Diese Nebenbedingungen können verwendet werden, um z.B. Änderungsraten der Kapazität, die Richtung der SoH-Korrektur, etc. zu beschränken oder zu bestrafen. Je nach Architektur und Formulierung des Gütemaßes und der Beschränkungen können unterschiedliche, aber an sich bekannte, Optimierungsverfahren zum Einsatz kommen.

Der so ermittelte Beobachter 14 kann dann den SoH, bzw. eine Kenngröße des SoH, bestimmen. In Fig.11 ist die mit dem kombinierten SoH/SoC-Beobachter geschätzte Kenngröße $C_{akt}$, bezogen auf die Nennkapazität $C_{init}$ einer Batterie, in Abhängigkeit der Anzahl voller Lade-/Entladezyklen Z dargestellt (mit Kreuzen). Mit Punkten ist der tatsächlich gemessene Kapazitätsabfall dargestellt. Daraus ist ersichtlich, dass sich der Alterungszustand SoH, bzw. eine Kenngröße dafür, durch das beschriebene Verfahren sehr gut schätzen lässt.

Nachdem der Beobachter für den Alterungszustand SoH auf den vergangenen Daten basiert, kann die SoH-Schätzung viel langsamer erfolgen, als die SoC-Schätzung. Der Beobachter für den SoC berücksichtigt dabei immer den aktuellen Schätzwert für den SoH, bzw. der Kenngröße dafür.

Im Falle eines vollständigen Beobachters wäre der Beobachter 14 für den Alterungszustand SoH im Beobachter 13 für den SoC integriert.

## Patentansprüche

1. Verfahren zur Ermittlung eines regelungstechnischen Beobachters (13) zur Schätzung des SoC einer Batterie (10), **dadurch gekennzeichnet, dass** das Verfahren die folgenden Schritte umfasst:

   - Vorgeben eines Ausgangs-Anregungssignals der Batterie (10), wobei das Anregungssignal aus einer zeitlichen Abfolge von einer Vielzahl von durch den Laststrom (I) und den SoC-Wert definierten Designpunkten besteht,
   - Vorgeben eines Ausgangsmodells der Batterie (10), mit einem Modellausgang (y) und Modellparametern ($\psi$),
   - Ermitteln eines optimierten Versuchsplans in Form einer optimierten zeitlichen Abfolge von Designpunkten mittels einer modellbasierten Design of Experiments Methode auf Basis der Fisher Information Matrix ($I_{FIM}$) definiert durch $I_{FIM} = \frac{1}{\sigma^2} \sum_{k=1}^{N} \frac{\partial y(k,\psi)}{\partial \psi} \frac{\partial y(k,\psi)^T}{\partial \psi}$ und eines Beurteilungskriteriums,
   - Beaufschlagen der Batterie (10) mit den einzelnen Designpunkten in der zeitlichen Sequenz gemäß dem ermittelten Versuchsplan, wobei dabei Messwerte von Zustandsgrößen der Batterie (10) erfasst werden,
   - Ermitteln eines nichtlinearen Modells der Batterie (10) auf Basis der ermittelten Messwerte und anhand eines lokalen Modellnetzwerks bestehend aus einer Anzahl von lokalen, linearen, zeitinvarianten, dynamischen Modellen ($LM_i$), die jeweils in bestimmten Bereichen der Eingangsgrößen Gültigkeit haben, wobei der Modellausgang als gewichtete Linearkombination der Ausgänge der lokalen Modelle ($LM_i$) bestimmt wird,
- Umwandeln der lokalen Modelle ($LM_i$) des Modellnetzwerkes in lokale, lineare Zustandsraummodelle, mit einem Zustandsvektor, der den SoC enthält,
- Erstellen eines lokalen Beobachters für jedes lokale, lineare Zustandsraummodell und
- Erstellen des regelungstechnischen Beobachters (13) aus einer Linearkombination der lokalen Beobachter.

**2.** Verfahren nach Anspruch 1, **dadurch gekennzeichnet, dass** der optimierte Versuchsplan durch Minimierung einer Ergebnisfunktion $J_{opt} = \alpha \frac{J_{FIM,init}}{J_{FIM,opt}} + (1-\alpha)\frac{T_{opt}}{T_{init}}$ ermittelt wird, wobei $J_{FIM}$ die Determinante der Fisher Information Matrix und $\alpha$ ein Gewichtungsfaktor ist.

**3.** Verfahren nach Anspruch 1, **dadurch gekennzeichnet, dass** jedes i-te lokale Modell ($LM_i$) des lokalen Modellnetzwerks (LMN) aus einer Gültigkeitsfunktion ($\Phi_\iota$) und einem Modellparametervektor $\theta_i$ besteht, wobei der Modellparametervektor ($\theta_i$) alle Modellparameter für das i-te Modell ($LM_i$) umfasst und die Gültigkeitsfunktion ($\Phi_i$) den Gültigkeitsbereich des i-ten lokalen Modells ($LM_i$) definiert, und ein lokaler Schätzwert der Ausgangsgröße $\hat{y}_i(k)$ des i-ten lokalen Modells ($LM_i$) zum Zeitpunkt k aus $\hat{y}_i(k) = x^T(k)\theta_i$ ermittelt wird, wobei x(k) einen Regressionsvektor bezeichnet, der gegenwärtige und vergangene Ein- und Ausgänge enthält, **dass** der globale Modellausgang $\hat{y}(k)$ aus einer Linearkombination mit einer Wichtung der lokalen Modellausgänge durch die Gültigkeitsfunktion ($\Phi_i$) gemäß $y(k) = \sum_{i=1}^{M} \Phi_i(k)\hat{y}_i(k)$ ermittelt wird **und dass** der Modellparametervektor ($\theta_i$) mittels einer Optimierung, die den Fehler zwischen geschätzter Ausgangsgröße und gemessener Ausgangsgröße minimiert, ermittelt wird.

**4.** Verfahren nach Anspruch 3, **dadurch gekennzeichnet, dass** für jedes i-te lokale Modell ($LM_i$) ein Zustandsvektor $z_i(k)=A_iz(k-1)+B_iu(k)$ angesetzt wird, wobei sich die Systemmatrix $A_i$ und die Eingangsmatrix $B_i$ aus dem ermittelten Modellparametervektor ($\theta_i$) ergeben, und sich der gesamte Systemzustand durch Wichtung der lokalen Zustände mit der Gültigkeitsfunktion ($\Phi_i$)zu $z(k) = \sum_{i=1}^{M} \Phi_i(k-1)\{A_iz(k-1) + B_iu(k)\}$ und der globale Modellausgang zu $y(k) = Cz(k)$, mit C=[1 0 ... 0 0], ergibt **und dass** für jeden lokalen Zustand ein lokaler Kalman Filter mit der Verstärkungsmatrix $K_i$ ermittelt wird, um den lokalen Zustand zu schätzen.

**5.** Verfahren nach Anspruch 4, **dadurch gekennzeichnet, dass** sich der geschätzte Zustand $\hat{z}(k)$, der den geschätzten SoC enthält, aus der Gleichung,

$$\hat{z}(k) = \sum_{i=1}^{M} \Phi_i(k-1)\{z_i^*(k) + K_i[y(k) - \hat{y}(k)]\} \text{ mit } z_i^*(k) = A_i\hat{z}(k-1) + B_iu(k)$$

und

$$\hat{y}(k) = \sum_{i=1}^{M} \Phi_i(k-1)Cz_i^*(k)$$

ergibt.

**6.** Verfahren nach einem der Ansprüche 1 bis 5, **dadurch gekennzeichnet, dass** durch zumindest eine Kenngröße ($C_{akt}$, $R_{akt}$) für den Alterungszustand (SoH) der Batterie (10) zumindest eine Eingangsgröße des lokalen Modellnetzwerks (LMN) skaliert wird.

**7.** Verfahren nach einem der Ansprüche 3 bis 6, **dadurch gekennzeichnet, dass** durch zumindest eine Kenngröße ($C_{akt}$, $R_{akt}$) für den Alterungszustand (SoH) der Batterie (10) zumindest ein Modellparameter des lokalen Modellnetzwerks (LMN) skaliert wird.

**8.** Verfahren nach Anspruch 6 oder 7, **dadurch gekennzeichnet, dass** der Beobachter (13) für den SoC um einen Beobachter (14) für die Kenngröße ($C_{akt}$, $R_{akt}$) erweitert wird.

**9.** Verfahren nach Anspruch 8, **dadurch gekennzeichnet, dass** durch den Beobachter (14) für den SoH ein Beobachtungsfehler (e) zwischen gemessener Ausgangsgröße (y) und geschätzter Ausgangsgröße ($\hat{y}$) des nichtlinearen Batteriemodells mit Hilfe eines vorgegebenen Gütemaßes für den Beobachtungsfehler (e) bezüglich der Kenngröße ($C_{akt}$, $R_{akt}$) minimiert wird.

## Claims

**1.** A method for determining a control observer (13) to estimate the SoC of a battery (10), **characterized in that** the method comprises the following steps:

- Specifying an initial excitation signal of the battery (10), wherein the excitation signal comprises a time sequence of a plurality of design points defined by the load current (I) and the SoC value;
- Specifying an initial model of the battery (10) having a model output (y) and model parameters ($\psi$);
- Determining an optimized experimental design in form of an optimized time sequence of design points by use of a model based design of experiments method on the basis of the Fisher information matrix ($I_{FIM}$), defined by $I_{FIM} = \frac{1}{\sigma^2}\sum_{k=1}^{N}\frac{\partial y(k,\psi)}{\partial \psi}\frac{\partial y(k,\psi)^T}{\partial \psi}$ and a judgment criterion;
- Impinging the battery (10) with the individual design points in the time-sequence according to the determined experimental design, wherein the measurements are obtained by state variables of the battery (10);
- Determining a nonlinear model of the battery (10) on the basis of the determined measurements and by a local model network comprising a number of local, linear, time-variant, and dynamic models ($LM_i$), which are respectively valid in specific ranges of the input variables, wherein the model output is determined as a weighted linear combination of the outputs of the local models ($LM_i$);
- Converting the local models ($LM_i$) of the model network into local, linear state space models having a state vector comprising the SoC;
- Creating a local observer for each local, linear state space model; and
- Creating the control observer (13) from a linear combination of the local observers.

**2.** The method according to Claim 1, **characterized in that** the optimized experimental design is determined by minimizing a result function $J_{opt} = \alpha\frac{J_{FIM,init}}{J_{FIM,opt}} + (1-\alpha)\frac{T_{opt}}{T_{init}}$, wherein $J_{FIM}$ is the determinant of the Fisher information matrix and $\alpha$ is a weighting factor.

**3.** The method according to Claim 1, **characterized in that** each i*th* local model ($LM_i$) of the local model network (LMN) comprises a validity function ($\Phi_i$) and a model parameter vector $\theta$, wherein the model parameter vector ($\theta_i$) includes all model parameter for the i*th* model ($LM_i$) and the validity function ($\Phi_i$) defines the validity range of the i*th* local model ($LM_i$), and a local estimate of output variable $\hat{y}_i(k)$ of the i*th* local model ($LM_i$) is determined at the point in time k from $\hat{y}_i(k) = x^T(k)\theta_i$' wherein x(k) references a regression vector, which comprises present and past inputs and outputs, **that** the global model output $\hat{y}(k)$ is determined from the linear combination by weighting the local model outputs via the validity function ($\Phi_i$) according to $y(k) = \sum_{i=1}^{M}\Phi_i(k)\hat{y}_i(k)$, **and that** the model parameter vector ($\theta i$) is determined by an optimization, which minimizes the error between estimated output variable and measured output variable.

**4.** The method according to Claim 3, **characterized in that** for each i*th* local model ($LM_i$) a state vector $z_i(k)=A_iz(k-1)+B_iu(k)$ is applied, wherein the system matrix $A_i$ and the input matrix $B_i$ result from the determined model parameter vector ($\theta_i$), and the total system state results by weighting the local states with the validity function ($\Phi_i$) in

$z(k)=\sum_{i=1}^{M}\Phi_i(k-1)\{A_i z(k-1)+B_i u(k)\}$ and the global model output in $y(k)=Cz(k)$, with C=[1 0 ... 0.0], **and that** for each local state a local Kalman filter having a gain matrix $K_i$ is determined to estimate the local state.

**5.** The method according to Claim 4, **characterized in that** the estimated state $\hat{z}(k)$, which comprises the estimated SoC, results from the equation

$$\hat{z}(k)=\sum_{i=1}^{M}\Phi_i(k-1)\{z_i^*(k)+K_i[y(k)-\hat{y}(k)]\} \text{ with } z_i^*(k)=A_i\hat{z}(k-1)+B_i u(k)$$

and

$$\hat{y}(k)=\sum_{i=1}^{M}\Phi_i(k-1)Cz_i^*(k)$$

**6.** The method according to one of Claims 1 through 5, **characterized in that** at least one input variable of the local model network (LMN) is scaled by at least one parameter ($C_{akt}$, $R_{akt}$) for the state of health (SoH) of the battery (10).

**7.** The method according to one of Claims 3 through 6, **characterized in that** at least one model parameter of the local model network (LMN) is scaled by at least one parameter ($C_{akt}$, $R_{akt}$) for the state of health (SoH) of the battery (10).

**8.** The method according to Claim 6 or 7, **characterized in that** the observer (13) for the SoC is extended by an observer (14) for the parameter ($C_{akt}$, $R_{akt}$).

**9.** The method according to Claim 8, **characterized in that** the observer (14) for the SoH minimizes an observation error (e) between the measured output variable (y) and the estimated output variable ($\hat{y}$) of the nonlinear battery model with the aid of a specified quality measure for the observation error (e) in relation to the parameter ($C_{akt}$, $R_{akt}$).

## Revendications

**1.** Procédé de détermination d'un observateur d'ingénierie de régulation (13) destiné à estimer l'état de charge Soc d'une batterie (10), **caractérisé en ce que** le procédé comprend les étapes suivantes consistant à :

- prescrire un signal d'excitation de sortie de la batterie (10), le signal d'excitation étant constitué d'une séquence temporelle d'un grand nombre de points de plan définis par le courant de charge (I) et la valeur SoC,
- prescrire un modèle de sortie de la batterie (10), comportant une sortie de modèle (y) et des paramètres de modèle ($\psi$),
- déterminer un plan d'expériences optimisé sous la forme d'une séquence temporelle optimisée des points de plan au moyen d'une méthode de Plan d'Expériences (Design of Expérience) basée sur un modèle à partir de la matrice d'information de Fisher ($I_{FIM}$) définie par $I_{FIM}=\frac{1}{\sigma^2}\sum_{k=1}^{N}\frac{\partial y(k,\psi)}{\partial\psi}\frac{\partial y(k,\psi)^T}{\partial\psi}$ et d'un critère de jugement,
- appliquer à la batterie (10) les points de plan individuels dans la séquence temporelle selon le plan d'expériences déterminé, des valeurs de mesure de grandeurs d'état de la batterie (10) étant détectées,
- déterminer un modèle non linéaire de la batterie (10) sur la base des valeurs de mesure déterminées et par référence à un réseau de modèles locaux constitué d'un certain nombre de modèles ($LM_i$) dynamiques, temporellement invariants, linéaires, locaux qui présentent chacun une validité dans des domaines déterminées des grandeurs d'entrée, la sortie de modèle étant déterminée sous forme d'une combinaison linéaire pondérée des sorties des modèles locaux ($LM_i$),
- convertir les modèles locaux ($LM_i$) du réseau de modèles en modèles d'espace d'états linéaires locaux, avec un vecteur d'état qui contient le SoC,

- créer un observateur local pour chaque modèle d'espace d'état linéaire local et
- créer l'observateur d'ingénierie de régulation (13) à partir d'une combinaison linéaire des observateurs locaux.

2. Procédé selon la revendication 1, **caractérisé en ce que** le plan d'expérience optimisé est déterminé par minimisation d'une fonction de résultat $J_{opt} = \alpha \frac{J_{FIM,init}}{J_{FIM,opt}} + (1-\alpha)\frac{T_{opt}}{T_{init}}$, $J_{FIM}$ étant le déterminant de la matrice d'information de Fisher, et $\alpha$ étant un facteur de pondération.

3. Procédé selon la revendication 1, **caractérisé en ce que** chaque i-ème modèle local ($LM_i$) du réseau de modèles locaux (LMN) est constitué d'une fonction de validité ($\Phi_i$) et d'un vecteur de paramètre de modèle $\theta_i$, le vecteur de paramètre de modèle ($\theta_i$) comportant tous les paramètres de modèle pour le i-ème modèle ($LM_i$) et la fonction de validité ($\Phi_i$) définissant le domaine de validité du i-ème modèle local ($LM_i$) et une valeur d'estimation locale de la grandeur de sortie $\hat{y}_i(k)$ du i-ème modèle local ($LM_i$) étant déterminée à l'instant k à partir de $\hat{y}_i(k) = x^T(k)\theta_i$, x(k) représentant un vecteur de régression qui contient des entrées et sorties présentes et passées, **en ce que** la sortie de modèle global $\hat{y}(k)$ est déterminée à partir d'une combinaison linéaire avec une pondération des sorties de modèles locaux par la fonction de validité ($\Phi_i$) conformément à $y(k) = \sum_{i=1}^{M} \Phi_i(k)\hat{y}_i(k)$ et **en ce que** le vecteur de paramètres de modèle ($\theta_i$) est déterminé au moyen d'une optimisation qui minimise l'erreur entre la grandeur de sortie estimée et la grandeur de sortie mesurée.

4. Procédé selon la revendication 3, **caractérisé en ce qu'**un vecteur d'état $z_i(k)=A_iz(k-1)+B_iu(k)$ est évalué pour chaque i-ème modèle local ($LM_i$), la matrice de système $A_i$ et la matrice d'entrée $B_i$ étant obtenues à partir du vecteur de paramètre de modèle ($\theta_i$) déterminé et tout l'état de système étant obtenu par pondération des états locaux avec la fonction de validité ($\Phi_i$) à $z(k) = \sum_{i=1}^{M} \Phi_i(k-1)\{A_iz(k-1) + B_iu(k)\}$ et la sortie de modèle global selon $y(k)=Cz(k)$, avec C=[1 0...0 0], et **en ce qu'**un filtre de Kalman local est déterminé pour chaque état local avec la matrice de gain $K_i$ pour estimer l'état local.

5. Procédé selon la revendication 4, **caractérisé en ce que** l'état estimé $\hat{z}(k)$, qui contient le SoC estimé, est obtenu à partir de l'équation $\hat{z}(k) = \sum_{i=1}^{M} \Phi_i(k-1)\{z_i^*(k) + K_i[y(k) - \hat{y}(k)]\}$ avec $z_i^*(k) = A_i\hat{z}(k-1) + B_iu(k)$ et $\hat{y}(k) = \sum_{i=1}^{M} \Phi_i(k-1)Cz_i^*(k)$.

6. Procédé selon l'une des revendications 1 à 5, **caractérisé en ce qu'**au moins une grandeur d'entrée du réseau de modèles locaux (LMN) est cadrée par au moins une grandeur caractéristique ($C_{akt}$, $R_{akt}$) de l'état de vieillissement (SoH) de la batterie (10).

7. Procédé selon l'une des revendications 3 à 6, **caractérisé en ce qu'**au moins un paramètre de modèle du réseau de modèles locaux (LMN) est cadré par au moins une grandeur caractéristique ($C_{akt}$, $R_{akt}$) de l'état de vieillissement (SoH) de la batterie (10).

8. Procédé selon la revendication 6 ou 7, **caractérisé en ce que** l'observateur (13) pour l'état de charge SoC est étendu d'un observateur (14) pour la grandeur caractéristique ($C_{ak}t$, $R_{akt}$).

9. Procédé selon la revendication 8, **caractérisé en ce qu'**une erreur d'observation (e) entre la grandeur de sortie mesurée (y) et la grandeur de sortie estimée (y) du modèle de batterie non linéaire est minimisée par l'observateur (14) pour SoH à l'aide d'une mesure de qualité prédéterminée de l'erreur d'observation (e) par rapport à la grandeur ($C_{akt}$, $R_{akt}$).

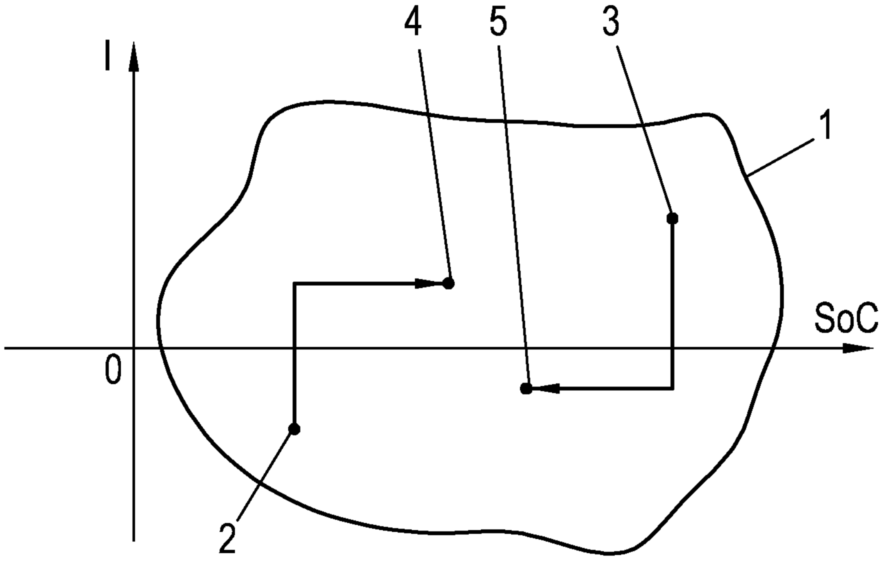


Fig. 1

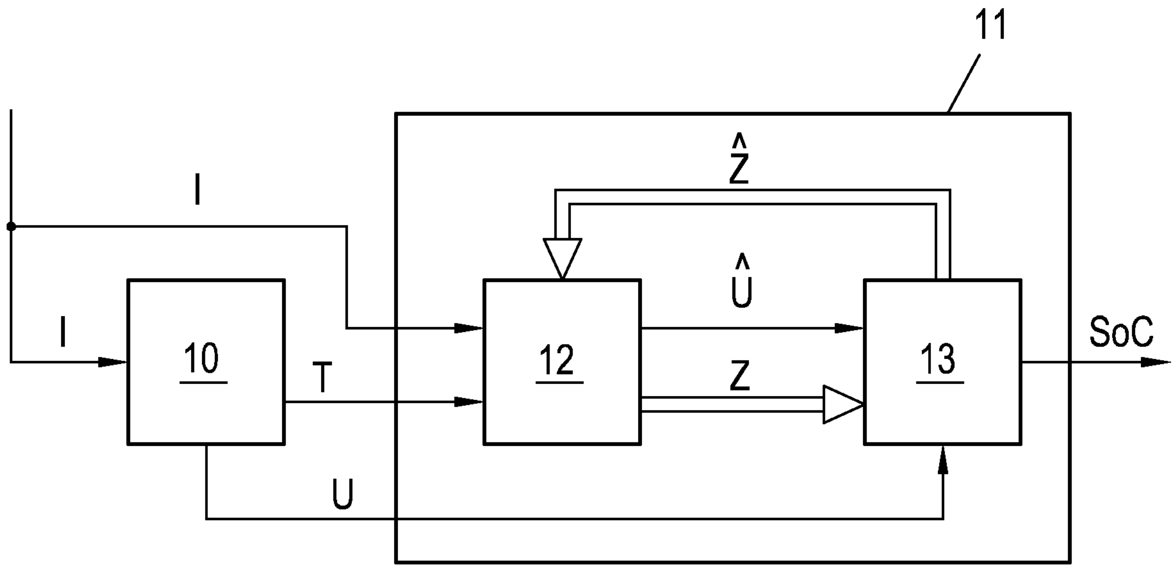


Fig. 5

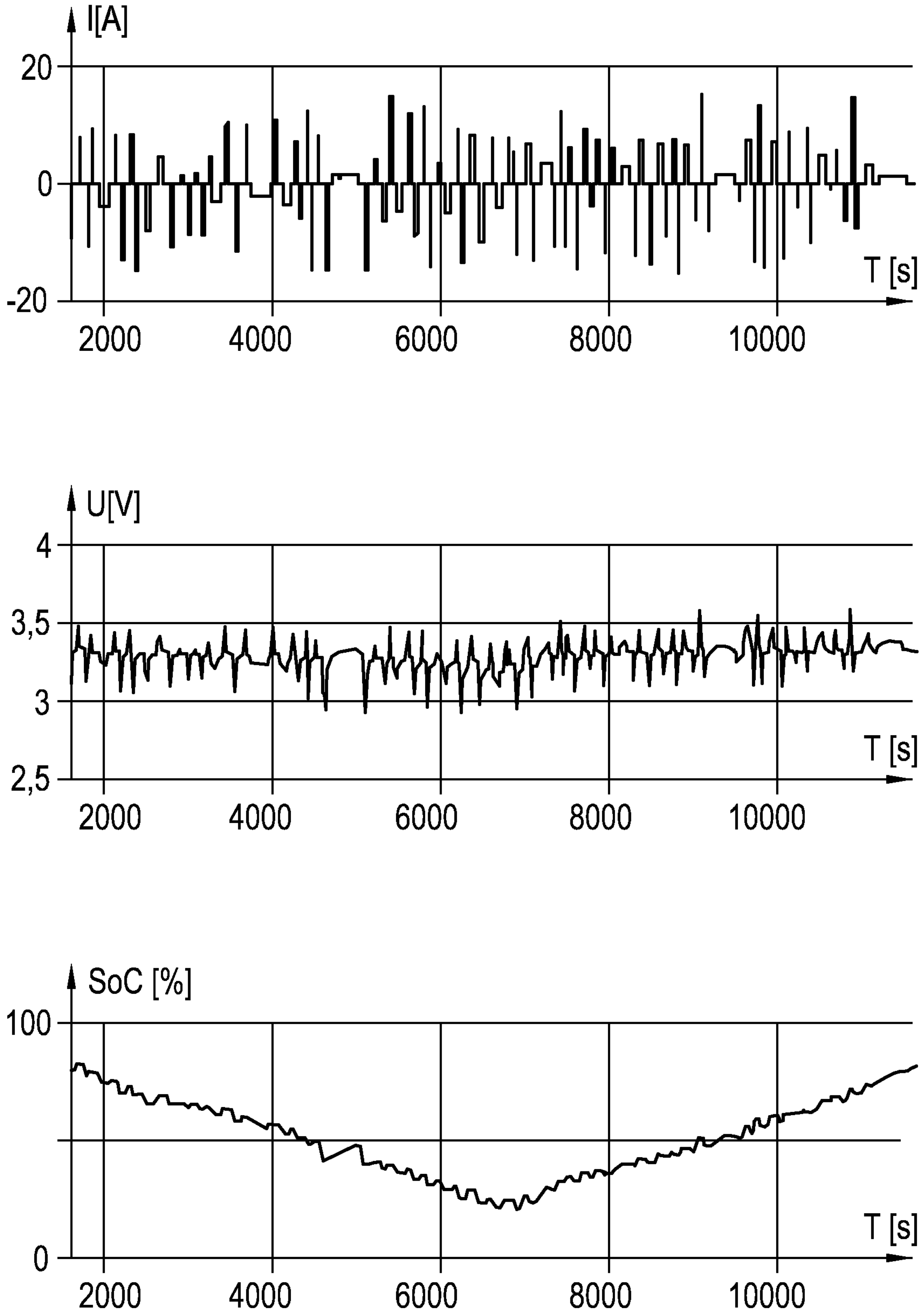
I[A]
20
0
-20
T [s]
2000
4000
6000
8000
10000
U[V]
4
3,5
3
2,5
T [s]
2000
4000
6000
8000
10000
SoC [%]
100
0
T [s]
2000
4000
6000
8000
10000

Fig. 2

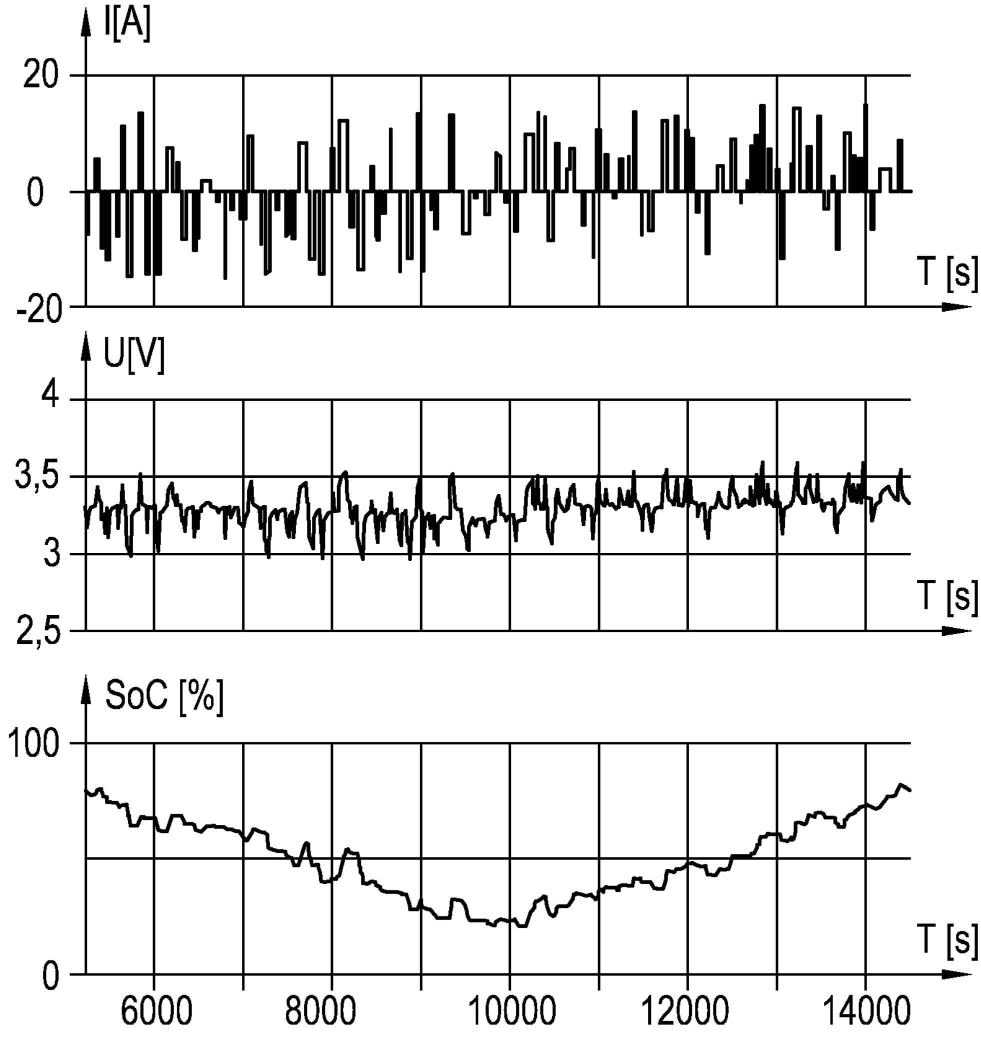
I[A]
20
0
-20
T [s]
U[V]
4
3,5
3
2,5
T [s]
SoC [%]
100
0
T [s]
6000
8000
10000
12000
14000

Fig. 3

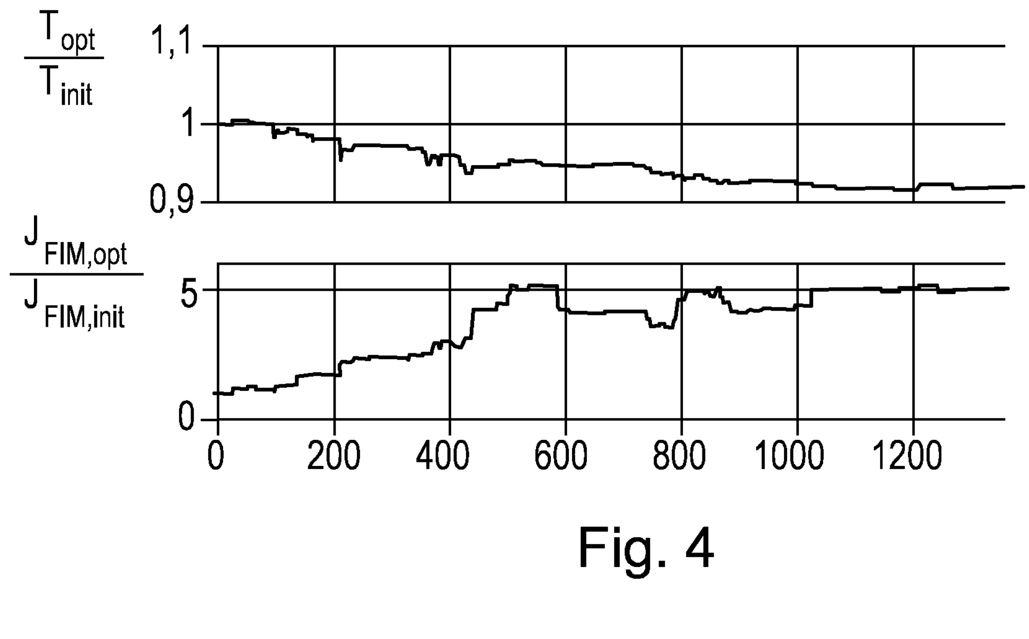
$\frac{T_{opt}}{T_{init}}$
1,1
1
0,9
$\frac{J_{FIM,opt}}{J_{FIM,init}}$
5
0
0
200
400
600
800
1000
1200

Fig. 4

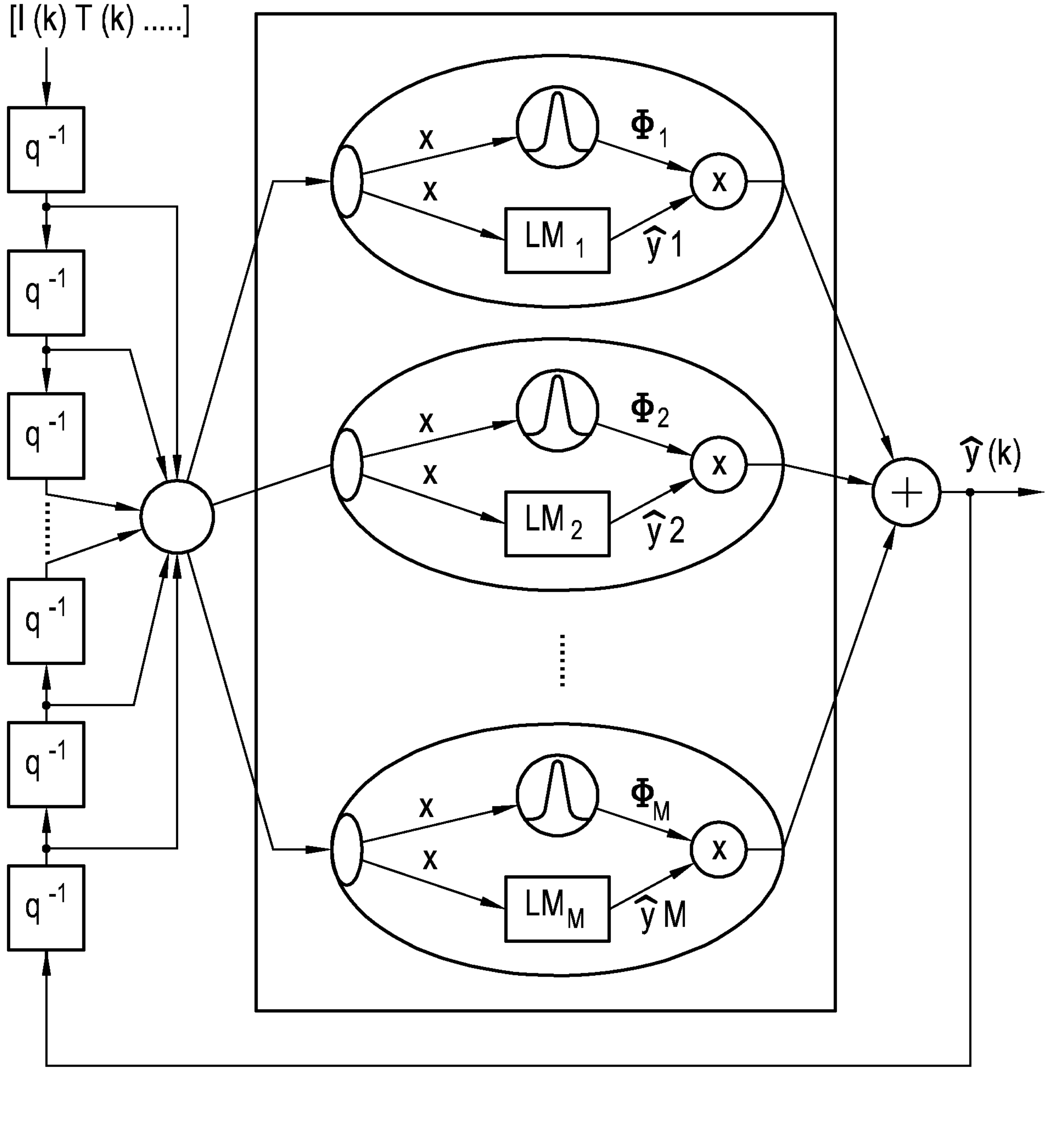


Fig. 6

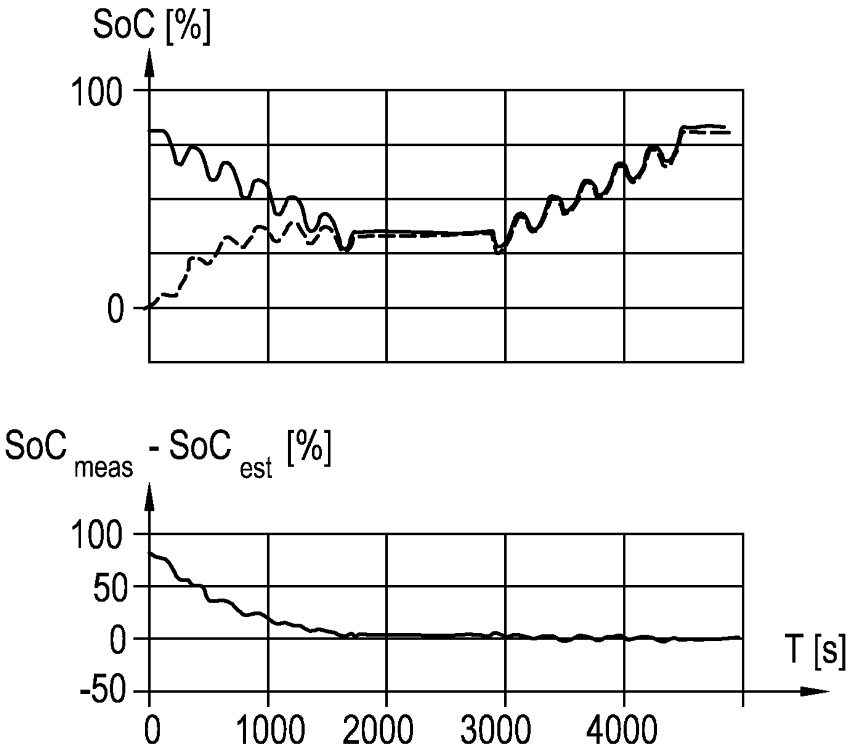
SoC [%]
100
0
SoC meas - SoC est [%]
100
50
0
-50
T [s]
0
1000
2000
3000
4000

Fig. 7

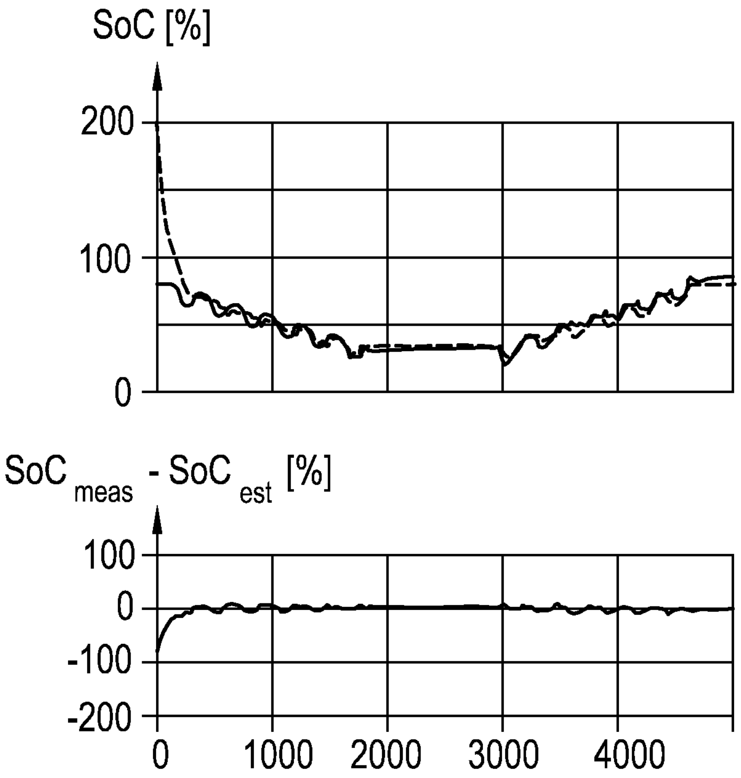
SoC [%]
200
100
0
SoC meas - SoC est [%]
100
0
-100
-200
0
1000
2000
3000
4000

Fig. 8

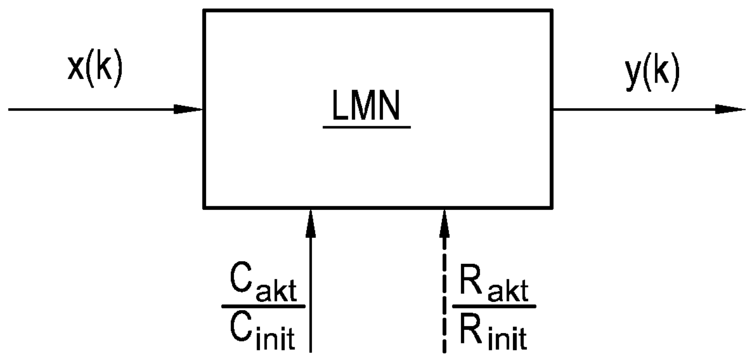
x(k)
LMN
y(k)
$\frac{C_{akt}}{C_{init}}$
$\frac{R_{akt}}{R_{init}}$

Fig. 9

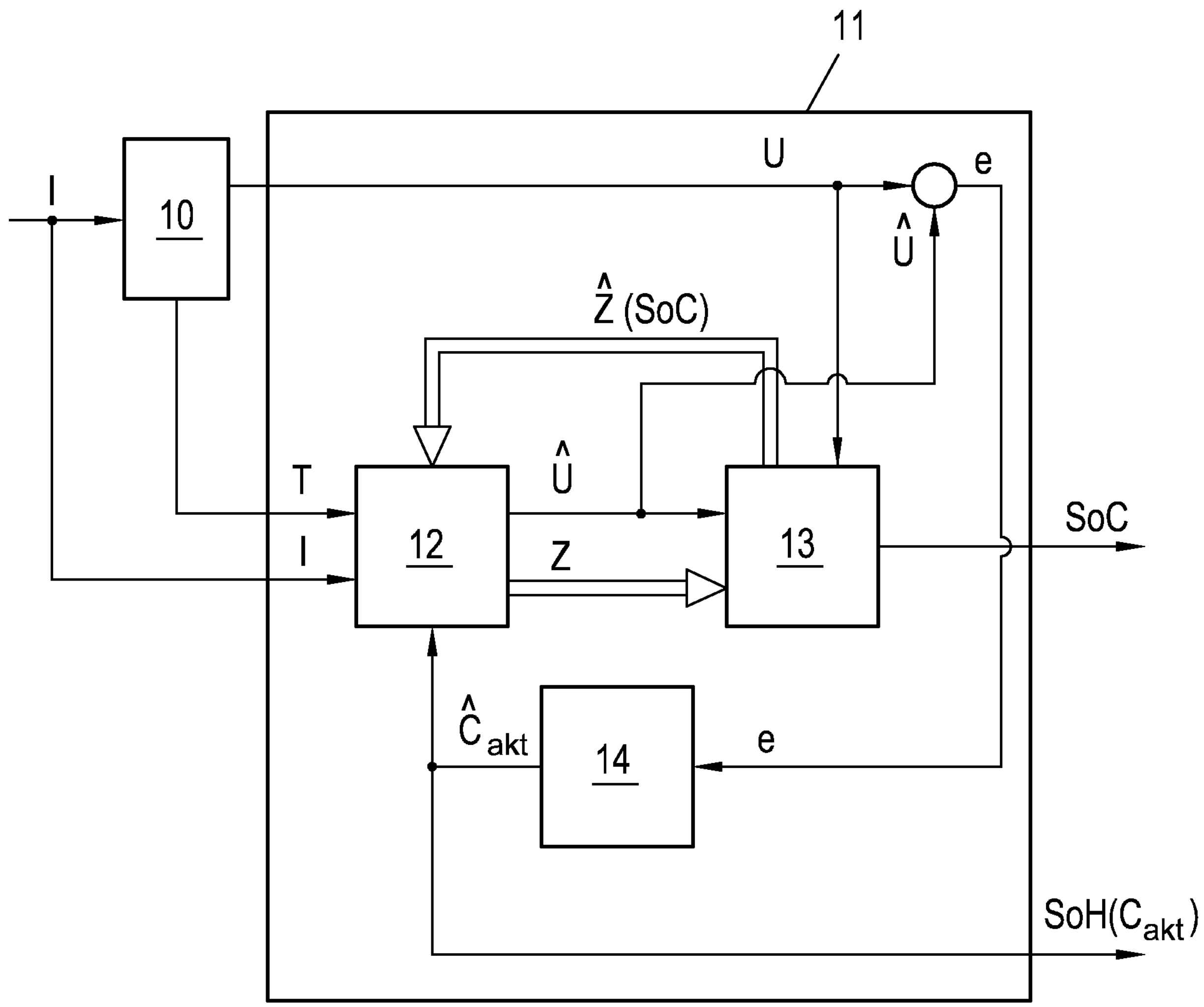
11
I
10
U
e
Û
Ẑ (SoC)
T
Û
12
13
SoC
I
Z
Ĉ akt
14
e
SoH($C_{akt}$)

Fig. 10

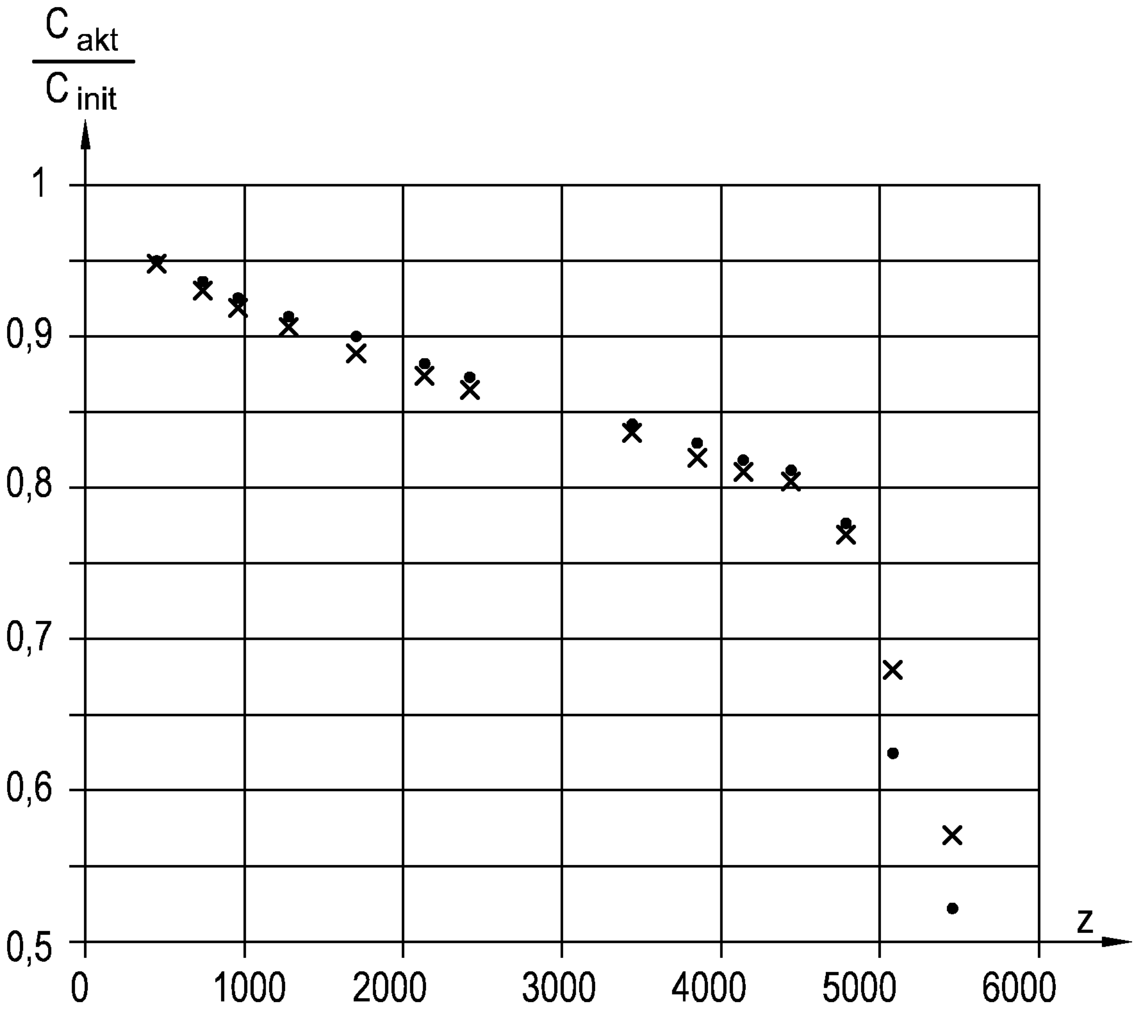


Fig. 11

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 102009046579 A1
- DE 102012210883 A1